# EUROPÄISCHE PATENTSCHRIFT

(11) **EP 4 281 789 B1**
(45) Veröffentlichungstag und Bekanntmachung des Hinweises auf die Patenterteilung: **03.12.2025**
(21) Anmeldenummer: 22700768.9
(22) Anmeldetag: 13.01.2022
(51) Int. Cl.: H03K 17/955, H03K 17/96, G01R 27/26

(54) **STÖRUNGSUNEMPFINDLICHE BESTIMMUNG EINER KAPAZITÄT**
INTERFERENCE-INSENSITIVE DETERMINATION OF A CAPACITANCE
DÉTERMINATION INSENSIBLE AUX INTERFÉRENCES D'UNE CAPACITÉ

(30) Priorität: 20.01.2021 DE 102021101132
(43) Veröffentlichungstag der Anmeldung: 29.11.2023
(73) Patentinhaber: Valeo Schalter und Sensoren GmbH, 74321 Bietigheim-Bissingen (DE)
(72) Erfinder: SCHMITT, Martin, 96476 Bad Rodach (DE); MUSAT, Ciprian, 94046 Creteil (FR)
(74) Vertreter: Ralf, Thorge
(86) Internationale Anmeldenummer: PCT/EP2022/050579
(87) Internationale Veröffentlichungsnummer: WO 2022/157054

(56) Entgegenhaltungen:
- EP-A1- 3 474 452
- DE-A1- 102017 124 309
- US-A1- 2010 283 485
- US-B1- 6 466 036

## Beschreibung

Die vorliegende Erfindung betrifft ein Verfahren zur Bestimmung einer Kapazität eines kapazitiven Elements, wobei während jedes Messzyklus einer Vielzahl aufeinanderfolgenden Messzyklen das kapazitive Element geladen wird und anschließend eine Ladungsmenge von dem kapazitiven Element auf ein weiteres kapazitives Element übertragen wird und nach der Vielzahl von Messzyklen ein Messwert betreffend eine während der Vielzahl von Messzyklen insgesamt auf das weitere kapazitive Element übertragene Gesamtladungsmenge bestimmt wird und die Kapazität des kapazitiven Elements abhängig von dem Messwert bestimmt wird. Die Erfindung betrifft ferner eine entsprechende Messanordnung zur Bestimmung einer Kapazität, ein Benutzereingabegerät mit einem kapazitiven Element und ein Computerprogrammprodukt.

Die EP 3 474 452 A1 offenbart Verfahren zum Auswerten eines Kapazitätswerts einer kapazitiven Sensorelektrode. Das Verfahren umfasst einen Auswertungsvorgang mit den folgenden Schritte: - Durchführen eines Ladevorgangs der Sensorelektrode,- Auswerten eines von dem Kapazitätswert der Sensorelektrode abhängigen Parameters. Eine erste Ladepulsdauer, die sich aus einer ersten Kopplungszeitdauer und einer ersten Entkopplungszeitdauer zusammensetzt, eines ersten Kopplungs- und Entkopplungszyklus und eine zweite Ladepulsdauer, die sich aus einer zweiten Kopplungszeitdauer und einer zweiten Entkopplungszeitdauer zusammensetzt, eines unmittelbar auf den ersten Kopplungs- und Entkopplungszyklus folgenden zweiten Kopplungs- und Entkopplungszyklus weichen voneinander in einer ersten Pulsdauerabweichung ab.

Die US 6 466 036 B1 offenbart eine Impulsschaltung, die aus Sätzen von drei oder mehr elektrischen Schaltelementen hergestellt sind, die so angeordnet sind, dass jedes der Schaltelemente eine Seite aufweist, die elektrisch entweder mit einer Versorgungsspannung oder mit einer elektrischen Masse verbunden ist. Darüber hinaus kann die Schaltung als Näherungsschalter konfiguriert werden, der nur eine Zweidrahtverbindung erfordert.

Die US 2010/283485 A1 offenbart ein Verfahren zum Erkennen der Änderung eines Kapazitätswertes eines Sensorkondensators bei Annäherung einer Person. Die Änderung wird erkannt, indem der Sensorkondensator durch Kopplung des Sensors an eine Spannungsversorgung aufgeladen wird. Die Spannungsversorgung wird während des Ladevorgangs von einem Tankkondensator getrennt. Die Ladung wird vom Sensorkondensator auf einen Tankkondensator übertragen. Die Spannungsversorgung wird während der Ladungsübertragung vom Tankkondensator getrennt. Der Ladevorgang und die Ladungsübergabe werden mehrmals wiederholt. Die Spannung des Tankkondensators wird überwacht. Es wird mindestens ein Wert ermittelt, der von der Änderungsrate der Spannung des Tankkondensators abhängt.

Im Dokument US 6,466,036 B1 wird ein Pulsschaltkreis zur Messung der Kapazität eines Sensorplättchens angegeben, der dazu in der Lage ist, wiederholt auf dem Sensorplättchens akkumulierte Ladung auf einen Kondensator zu übertragen und nach einer Vielzahl von Wiederholungen die übertragene Ladungsmenge auszulesen beziehungsweise eine entsprechende Spannung auszulesen, um die Kapazität des Sensorplättchens zu bestimmen.

Solche Schaltkreise können beispielsweise zur kapazitiven Erkennung von Benutzereingaben verwendet werden, wobei die Annäherung oder Berührung des Sensorplättchens durch den Benutzer die Kapazität der Sensorplatte ändert und dadurch die Berührung oder Annäherung detektiert werden kann. Insbesondere kann eine solche Berührungserkennung für Anwendungen im Innenraum von Kraftfahrzeugen eingesetzt werden, beispielsweise bei der Erkennung der Betätigung von berührungsempfindlichen Bedienfeldern oder Bedienelementen.

Da die individuellen Ladungsübertragungen von dem Sensorplättchen auf den weiteren Kondensator wiederholt mit einer vorab festgelegten Frequenz erfolgen, können die entsprechenden Schaltkreise und Messverfahren durch externe Störeinflüsse mit ähnlichen Frequenzen beeinflusst werden. Dadurch können Genauigkeit und Zuverlässigkeit der Bestimmung der Kapazität und dementsprechend die Zuverlässigkeit der Erkennung der Berührung reduziert werden.

Bestimmten Frequenzbereichen kann mit analogen Tiefpassfiltern beziehungsweise digitalen Filtern begegnet werden. Bei typischen Abtastfrequenzen in der Größenordnung von 10 µs und einer entsprechenden Shannon- oder Nyquist-Frequenz in der Größenordnung von 50 kHz bleiben beispielsweise Störungen oberhalb der Shannon-Frequenz und unterhalb einer Grenze für die Tiefpassfilterung in der Größenordnung von einem oder mehreren MHz unberücksichtigt.

Vor diesem Hintergrund ist eine Aufgabe der vorliegenden Erfindung, ein verbessertes Konzept zum Bestimmen einer Kapazität eines kapazitiven Elements anzugeben, durch das der Einfluss von externen Störungen, insbesondere in Form von elektromagnetischen Wellen, reduziert werden kann.

Diese Aufgabe wird gelöst durch den jeweiligen Gegenstand der unabhängigen Ansprüche. Vorteilhafte Weiterbildungen und bevorzugte Ausführungsformen sind Gegenstand der abhängigen Ansprüche.

Das verbesserte Konzept beruht auf der Idee, die Abtastfrequenz beziehungsweise eine entsprechende Zeitdauer einer Vielzahl aufeinanderfolgender Messzyklen zu verändern.

Gemäß dem verbesserten Konzept wird ein Verfahren zur Bestimmung einer Kapazität eines kapazitiven Elements angegeben. Dabei wird das kapazitive Element während jedes Messzyklus einer Vielzahl aufeinanderfolgender Messzyklen geladen, insbesondere partiell geladen, und anschließend wird innerhalb desselben Messzyklus eine Ladungsmenge von dem kapazitiven Element auf ein weiteres kapazitives Element übertragen. Nach der Vielzahl von Messzyklen, also insbesondere nach Ende aller Messzyklen der Vielzahl von Messzyklen, wird, insbesondere mittels einer Recheneinheit, ein Messwert betreffend eine während der Vielzahl von Messzyklen insgesamt auf das weitere kapazitive Element übertragene Gesamtladungsmenge bestimmt. Die Kapazität des kapazitiven Elements wird, insbesondere mittels der Recheneinheit, abhängig von dem Messwert bestimmt. Die Vielzahl von Messzyklen enthält dabei eine erste Untermenge von Messzyklen sowie eine zweite Untermenge von Messzyklen. Für die erste Untermenge wird mittels der Recheneinheit eine erste Zeitdauer festgelegt und für die zweite Untermenge wird mittels der Recheneinheit eine zweite Zeitdauer festgelegt, die sich von der ersten Zeitdauer unterscheidet.

Die Zeitdauer eines Messzyklus entspricht dabei der Zeit, die von Anfang bis zum Ende des gesamten jeweiligen Messzyklus verstreicht. Die Zeitdauer eines Messzyklus kann also als inverse Abtastfrequenz verstanden werden. Die erste und die zweite Zeitdauer werden also insbesondere mittels der Recheneinheit festgelegt, bevor oder wenn der jeweilige Messzyklus beginnt.

Mit anderen Worten besitzt jeder Messzyklus der ersten Untermenge die erste Zeitdauer, und jeder Messzyklus der zweiten Untermenge besitzt die zweite Zeitdauer.

Die Messzyklen der ersten Zeitdauer folgen insbesondere nicht alle aufeinander. Dementsprechend folgen auch die Messzyklen der zweiten Untermenge nicht alle aufeinander. Beispielsweise kann nach jedem Messzyklus der ersten Untermenge zuerst ein Messzyklus der zweiten Untermenge folgen bevor wieder ein weiterer Messzyklus der ersten Untermenge folgt und so weiter. Die Vielzahl von Messzyklen kann außer der ersten und der zweiten Untermenge auch eine oder mehrere weitere Untermengen mit jeweils wiederum verschiedenen weiteren Zeitdauern beinhalten. Im Verlauf der Vielzahl von Messzyklen können sich dabei Messzyklen mit unterschiedlichen Zeitdauern, also Messzyklen aus unterschiedlichen Untermengen, abwechseln, so dass sich die jeweilige Zeitdauer zweier aufeinanderfolgender Messzyklen der Vielzahl von Messzyklen stets voneinander unterscheidet.

Zum Bestimmen des Messwerts kann beispielsweise eine an dem weiteren kapazitiven Element anliegende Spannung beziehungsweise die über dem weiteren kapazitiven Element abfallende Spannung gemessen werden. Der Messwert entspricht also insbesondere einem Spannungswert oder hängt von einem entsprechenden Spannungswert des weiteren kapazitiven Elements ab. Die Spannungsmessung zur Bestimmung des Messwerts erfolgt dabei insbesondere erst, wenn die Vielzahl von Messzyklen beendet ist.

Die während eines Messzyklus von dem kapazitiven Element auf das weitere kapazitive Element übertragene Ladungsmenge entspricht nicht notwendigerweise genau der Ladungsmenge, die beim Laden des kapazitiven Elements während desselben Messzyklus auf das kapazitive Element geladen wurde. Beispielsweise kann beim Laden des kapazitiven Elements ein Ladungsausgleich zwischen dem kapazitiven Element und dem weiteren kapazitiven Element unterbunden werden und zum Übertragen der Ladungsmenge kann der Ladungsausgleich zwischen dem kapazitiven Element und dem weiteren kapazitiven Element zugelassen werden.

Während die Ladung sich im Verlauf der Vielzahl von aufeinanderfolgenden Messzyklen auf dem weiteren kapazitiven Element zur Gesamtladungsmenge akkumuliert, kann das kapazitive Element beispielsweise nach jedem einzelnen Messzyklus oder innerhalb jedes einzelnen Messzyklus entladen, also zurückgesetzt, werden.

Ein Messzyklus kann also mehrere aufeinanderfolgende Abschnitte beinhalten, die unterschiedlichen Zuständen des kapazitiven Elements und des weiteren kapazitiven Elements beziehungsweise eines Schaltkreises mit dem kapazitiven Element und dem weiteren kapazitiven Element entsprechen. Das kapazitive Element kann beispielsweise als Kondensator ausgestaltet sein oder eine einzelne Sensorfläche beinhalten, wobei die Kapazität des kapazitiven Elements dann beispielsweise durch die Eigenkapazität der Sensorfläche, beispielsweise gegenüber einem Massepotential, gegeben sein kann.

Das weitere kapazitive Element kann ebenfalls als Kondensator ausgestaltet sein. Die Dimensionierung des weiteren kapazitiven Elements ist dabei insbesondere derart gewählt, dass eine Kapazität des weiteren kapazitiven Elements um ein Vielfaches größer ist eine maximale Kapazität des kapazitiven Elements, beispielsweise um einen Faktor in der Größenordnung 10 bis 1000 größer, insbesondere in der Größenordnung 100 bis 1000 größer.

Indem die Bestimmung der Kapazität des kapazitiven Elements also indirekt über die auf das weitere kapazitive Element übertragene Gesamtladungsmenge erfolgt, kann die Genauigkeit bei der Kapazitätsbestimmung signifikant erhöht werden, da nicht die sehr viel geringeren Spannungen, die an dem kapazitiven Element selbst anliegen, gemessen und ausgewertet werden müssen.

Dadurch, dass die jeweiligen Messzyklen der ersten und der zweiten Untermenge voneinander verschiedene Zeitdauern aufweisen, sich die Abtastfrequenz während der Vielzahl von Messzyklen also verändert, wird der Einfluss durch externe Störungen, die elektromagnetischen Wellen mit einer näherungsweise monofrequenten spektralen Charakteristik entsprechen, reduziert. Insbesondere kann eine solche externe Störung zwar einzelne Messzyklen der Vielzahl von Messzyklen beeinflussen, in der Regel wird sie jedoch nicht alle Messzyklen beeinflussen, da diese entsprechend verstimmte Zeitdauern oder Abtastfrequenzen aufweisen. Beeinflusst die externe Störung beispielsweise die erste Untermenge von Messzyklen, weil eine dominante Frequenz der externen Störung der näherungsweise dem Inversen der ersten Zeitdauer entspricht, so beeinflusst sie nicht die Messzyklen der zweiten Untermenge und umgekehrt.

Gemäß einer erfindungsgemäßen Ausführungsform des Verfahrens nach dem verbesserten Konzept enthält jeder der Messzyklen einen Ladeabschnitt, wobei das Laden des kapazitiven Elements während des Ladeabschnitts erfolgt, insbesondere ausschließlich während des Ladeabschnitts. Jeder der Messzyklen weist außerdem einen Übertragungsabschnitt auf, wobei das Übertragen der Ladungsmenge von dem kapazitiven Element auf das weitere kapazitive Element während des Übertragungsabschnitts erfolgt, insbesondere ausschließlich während des Übertragungsabschnitts.

Der Übertragungsabschnitt liegt dabei nach dem Ladeabschnitt desselben Messzyklus, folgt aber nicht notwendigerweise unmittelbar auf diesen. Insbesondere beinhaltet jeder Messzyklus der Vielzahl von Messzyklen eine Vielzahl aufeinanderfolgender Abschnitte, die den Ladeabschnitt und den Übertragungsabschnitt enthalten. Der Unterschied der ersten Zeitdauer von der zweiten Zeitdauer beispielsweise in einem einzigen der Abschnitte realisiert werden oder auf mehrere Abschnitte verteilt sein.

Gemäß zumindest einer Ausführungsform wird zum Festlegen der ersten Zeitdauer eine erste Ladedauer für den jeweiligen Ladeabschnitt der Messzyklen der ersten Untermenge festgelegt, und zum Festlegen der zweiten Zeitdauer wird eine zweite Zeitdauer für den jeweiligen Ladeabschnitt der Messzyklen der zweiten Untermenge festgelegt, wobei die zweite Ladedauer von der ersten Ladedauer unterscheidet.

Insbesondere ist die erste Ladedauer für alle Ladeabschnitte der Messzyklen der Untermenge dieselbe und analog ist die zweite Ladedauer für alle Ladeabschnitte der Messzyklen der zweiten Untermenge dieselbe.

Gemäß zumindest einer Ausführungsform wird zum Festlegen der ersten Zeitdauer eine erste Übertragungsdauer für den jeweiligen Übertragungsabschnitt der Messzyklen der ersten Untermenge festgelegt, und zum Festlegen der zweiten Zeitdauer wird eine zweite Übertragungsdauer für den jeweiligen Übertragungsabschnitt der Messzyklen der zweiten Untermenge festgelegt, wobei sich die zweite Übertragungsdauer von der ersten Übertragungsdauer unterscheidet.

Insbesondere können zum Festlegen der ersten und der zweiten Zeitdauer lediglich die entsprechenden ersten und zweiten Übertragungsdauern unterschiedlich voneinander festgelegt werden, wohingegen die Ladedauer für alle Ladeabschnitte der Messzyklen der Vielzahl von Messzyklen, also insbesondere der ersten und der zweiten Untermenge, gleich ist.

Im Prinzip können beliebige Abschnitte des Messzyklus in ihrer Zeitdauer verändert werden. Je nach Ausführungsform des entsprechenden Schaltkreises kann es vorteilhaft sein, die Übertragungsdauer der Übertragungsabschnitte zu verändern, um Leckströme in die Auswerteelektronik zu vermeiden.

Gemäß einer erfindungsgemäßen Ausführungsform weist jeder der Messzyklen einen Zwischenabschnitt zwischen dem Ladeabschnitt und dem ersten Übertragungsabschnitt auf, wobei das kapazitive Element während des Zwischenabschnitts weder geladen oder entladen wird.

Gemäß einer alternativen oder zusätzlichen erfindungsgemäßen Ausführungsform weist jeder der Messzyklen einen weiteren Zwischenabschnitt vor dem Ladeabschnitt oder nach dem Übertragungsabschnitt auf, wobei das kapazitive Element während des weiteren Zwischenabschnitts weder geladen noch entladen wird.

Beispielsweise kann jeder Messzyklus den Ladeabschnitt, den Zwischenabschnitt, den Übertragungsabschnitt und den weiteren Zwischenabschnitt in dieser Reihenfolge beinhalten oder daraus bestehen. Alternativ kann jeder der Messzyklen den weiteren Zwischenabschnitt, den Ladeabschnitt, den Zwischenabschnitt und den Übertragungsabschnitt in dieser Reihenfolge beinhalten oder daraus bestehen.

Wie oben erläutert, kann durch entsprechende Beschaltung des kapazitiven Elements und des weiteren kapazitiven Elements ein Ladungsausgleich zwischen dem kapazitiven Element und dem weiteren kapazitiven Element während des Ladeabschnitts unterbunden werden und während des Übertragungsabschnitts zugelassen werden. Durch die Zwischenabschnitte kann vermieden werden, dass beim Umschalten von dem Ladeabschnitt zu dem Übertragungsabschnitt oder umgekehrt Leckströme von dem weiteren kapazitiven Element ausgehend die Messung verfälschen.

Gemäß einer erfindungsgemäßen Ausführungsform wird zum Festlegen der ersten Zeitdauer eine erste Zwischendauer für den jeweiligen Zwischenabschnitt der Messzyklen der ersten Untermenge festgelegt, und zum Festlegen der zweiten Zeitdauer wird eine zweite Zwischendauer für den jeweiligen Zwischenabschnitt der Messzyklen der zweiten Untermenge festgelegt, wobei sich die zweite Zwischendauer von der ersten Zwischendauer unterscheidet.

Gemäß einer alternativen oder zusätzlichen erfindungsgemäßen Ausführungsform wird zum Festlegen der ersten Zeitdauer eine erste weitere Zwischendauer für den jeweiligen weiteren Zwischenabschnitt der Messzyklen der ersten Untermenge festgelegt, und zum Festlegen der zweiten Zeitdauer wird eine zweite weitere Zwischendauer für den jeweiligen weiteren Zwischenabschnitt der Messzyklen der zweiten Untermenge festgelegt, wobei sich die zweite weitere Zwischendauer von der ersten weiteren Zwischendauer unterscheidet.

Gemäß zumindest einer Ausführungsform wird mittels der Recheneinheit für jeden Messzyklus der Vielzahl von Messzyklen ein Zählerstand eines Zählers gesetzt und eine Zeitdauer für den jeweiligen Messzyklus abhängig von dem jeweiligen gesetzten Zählerstand festgelegt.

Die auf diese Weise festgelegten Zeitdauern für die Messzyklen der Vielzahl von Messzyklen beinhalten insbesondere die erste Zeitdauer für die erste Untermenge von Messzyklen sowie die zweite Zeitdauer für die zweite Untermenge von Messzyklen.

Insbesondere erfolgt eine eindeutige Zuordnung des jeweiligen gesetzten Zählerstandes zu einer entsprechenden Zeitdauer. Mit anderen Worten kann der Zähler eine vorgegebene endliche Menge von Zählerständen annehmen, wobei jeder der Zählerstände genau einer Zeitdauer entspricht. Die erste Zeitdauer entspricht also beispielsweise einem ersten Zählerstand, und die zweite Zeitdauer entspricht einem zweiten Zählerstand, der von dem ersten Zählerstand verschieden ist.

Der Zähler kann dabei insbesondere als Hardware oder als Software implementiert sein. Der Zähler kann beispielsweise als binärer Zähler ausgestaltet sein, so dass der Zähler eine Anzahl von n Bits kodieren kann, wobei n ≥ 1 ist, vorzugsweise n ≥ 2, beispielsweise gleich n = 3, n = 4 oder n = 5. Dementsprechend ist die Anzahl der Zählerstände und somit die Anzahl der kodierbaren Zeiträume für die Messzyklen gleich 2ⁿ.

Die Anzahl der Messzyklen der Vielzahl von Messzyklen kann prinzipiell größer oder kleiner als 2ⁿ sein, ist vorzugsweise jedoch größer als 2ⁿ. Für n = 3, n = 4, n = 5 oder n = 6 ergäbe sich entsprechend 2ⁿ = 8, 2ⁿ = 16, 2ⁿ = 32 beziehungsweise 2ⁿ = 64. Die Anzahl der Messzyklen der Vielzahl von Messzyklen ist vorzugsweise größer oder gleich 100, beispielsweise größer oder gleich 200, größer oder gleich 300, größer oder gleich 400 oder größer oder gleich 500. Beispielsweise liegt die Anzahl der Messzyklen der Vielzahl von Messzyklen im Bereich zwischen 100 und 1000.

In Ausführungsformen, in denen die Anzahl der Messzyklen größer ist als 2n, durchläuft der Zähler also insbesondere mehrfach alle seine möglichen Zählerstände. Dementsprechend haben in solchen Ausführungsformen mindestens zwei Messzyklen der Vielzahl von Messzyklen dieselbe Zeitdauer. Dies ist jedoch nicht notwendigerweise der Fall. Falls aus anwendungsspezifischer Sicht größere Zähler in Frage kommen, also insbesondere größere Werte für n, kann 2ⁿ auch größer oder gleich der Anzahl von Messzyklen sein, beispielsweise für eine Anzahl von Messzyklen gleich 300 und n ≥ 9.

Durch die Verwendung des Zählers in der beschriebenen Weise kann eine besonders einfache Variation der Zeitdauern der Messzyklen erreicht werden.

Beispielsweise kann der Zählerstand ausgehend von einem initialen Zählerstand für jeden der Messzyklen der Vielzahl von Messzyklen um ein vorgegebenes Inkrement, beispielsweise um 1, erhöht werden, solange der Zählerstand kleiner oder gleich einem vorgegebenen maximalen Zählerstand ist. Der Zählerstand kann auf den initialen Zählerstand zurückgesetzt werden, wenn der Zählerstand den maximalen Zählerstand erreicht hat.

Der initiale Zählerstand kann beispielsweise gleich 0 sein und der maximale Zählerstand gleich 2ⁿ⁻¹, wobei das Inkrement gleich 1 ist. Dabei kann der Zählerstand beispielsweise zu Beginn, während oder kurz vor jedem der Messzyklen entsprechend verändert werden.

Gemäß zumindest einer Ausführungsform gilt der Zusammenhang N ≤ M, wobei M die Anzahl der Messzyklen der Vielzahl von Messzyklen bezeichnet, (N-1)*I eine ganze Zahl ist, die eine Differenz zwischen dem maximalen Zählerstand und dem initialen Zählerstand bezeichnet und I das Inkrement bezeichnet.

Gemäß zumindest einer Ausführungsform wird mittels der Recheneinheit für jeden Messzyklus der Vielzahl von Messzyklen die jeweilige Zeitdauer als Summe einer vorgegebenen, für alle Messzyklen der Vielzahl von Messzyklen konstanten Mindestzeitdauer und einer von dem jeweiligen gesetzten Zählerstand abhängigen zusätzlichen Zeitdauer festgelegt.

Die zusätzliche Zeitdauer ist dabei insbesondere direkt proportional zu dem Zählerstand. Der maximale Zählerstand entspricht dabei also insbesondere einer maximalen zusätzlichen Zeitdauer.

Die maximale zusätzliche Zeitdauer kann dabei insbesondere kleiner sein als die Mindestzeitdauer. Beispielsweise ist die maximale zusätzliche Zeitdauer kleiner oder gleich 10% der Mindestzeitdauer, beispielsweise kleiner oder gleich 5 % der Mindestzeitdauer oder kleiner oder gleich 1 % der Mindestzeitdauer. Die Mindestzeitdauer kann beispielsweise zwischen 0,5 % und 5 % oder zwischen 0,5 % und 2 % der Mindestzeitdauer liegen. Es hat sich gezeigt, dass solche Variationen der Zeitdauer gut geeignet sind, um Einflüsse externer Störungen ausreichend zu reduzieren.

Gemäß zumindest einer Ausführungsform liegt die Mindestzeitdauer in einem Bereich von 0,5 µs und 30 µs, insbesondere in einem Bereich zwischen 1 µs und 20 µs.

Gemäß zumindest einer Ausführungsform ist die jeweilige zusätzliche Zeitdauer kleiner oder gleich einem Zehntel der Mindestzeitdauer, insbesondere kleiner oder gleich einem Fünfzigstel der Mindestzeitdauer, beispielsweise kleiner oder gleich einem Hundertstel der Mindestzeitdauer.

Gemäß dem verbesserten Konzept wird auch ein Verfahren zur Detektion einer Benutzereingabe angegeben, wobei die Benutzereingabe die Berührung eines kapazitiven Elements durch einen Benutzer beinhaltet. Das Verfahren zur Detektion der Benutzereingabe nach dem verbesserten Konzept beinhaltet die Durchführung eines Verfahrens zur Bestimmung einer Kapazität des kapazitiven Elements gemäß dem verbesserten Konzept. Die so bestimmte Kapazität des kapazitiven Elements wird mittels der Recheneinheit mit einem vorgegebenen Schwellwert verglichen, und die Benutzereingabe oder die Berührung wird mittels der Recheneinheit abhängig von einem Ergebnis des Vergleichs detektiert.

Gemäß dem verbesserten Konzept wird auch eine Messanordnung zur Bestimmung einer Kapazität eines kapazitiven Elements angegeben. Die Messanordnung weist einen Anschluss auf, um das kapazitive Element mit der Messanordnung zu verbinden und einen Schaltkreis. Der Schaltkreis ist dazu eingerichtet, während jedes Messzyklus einer Vielzahl von aufeinanderfolgenden Messzyklen das kapazitive Element mit einer Spannungsquelle zu verbinden, um das kapazitive Element zu laden und anschließend eine Ladungsmenge von dem kapazitiven Element auf ein weiteres kapazitives Element der Messanordnung zu übertragen. Die Messanordnung weist eine Recheneinheit auf, die dazu eingerichtet ist, nach der Vielzahl von Messzyklen einen Messwert betreffend eine während der Vielzahl von Messzyklen insgesamt auf das weitere kapazitive Element übertragene Gesamtladungsmenge zu bestimmen und die Kapazität des kapazitiven Elements abhängig von den Messwerten zu bestimmen. Die Recheneinheit ist dazu eingerichtet, für eine erste Untermenge der Vielzahl von Messzyklen eine erste Zeitdauer festzulegen und für eine zweite Untermenge der Vielzahl von Messzyklen eine zweite Zeitdauer festzulegen, die sich von der ersten Zeitdauer unterscheidet.

Im Allgemeinen ist das kapazitive Element nicht notwendigerweise Bestandteil der Messanordnung. In verschiedenen Ausführungsformen kann die Messanordnung, insbesondere der Schaltkreis, jedoch das kapazitive Element beinhalten. Das weitere kapazitive Element kann beispielsweise ebenfalls Teil des Schaltkreises sein.

Ebenso ist im Allgemeinen die Spannungsquelle nicht notwendigerweise Bestandteil der Messanordnung. Die Messanordnung kann in verschiedenen Ausführungsformen aber auch die Spannungsquelle beinhalten.

Um das kapazitive Element mit der Spannungsquelle zu verbinden beziehungsweise um die Ladungsmenge von dem kapazitiven Element auf das weitere kapazitive Element zu übertragen, kann der Schaltkreis beispielsweise entsprechende Schaltelemente sowie eine Steuerung zur Steuerung der Schaltelemente aufweisen. Die Steuerung kann in verschiedenen Ausgestaltungsformen auch Teil der Recheneinheit sein.

Die Recheneinheit kann insbesondere einen Mikrocontroller beinhalten.

Gemäß zumindest einer Ausführungsform beinhaltet die Recheneinheit einen Analog-Digital-Wandler, ADC, der mit dem weiteren kapazitiven Element verbindbar ist, um den Messwert zu bestimmen.

Weitere Ausführungsformen der Messanordnung nach dem verbesserten Konzept folgen direkt aus den verschiedenen Ausgestaltungsformen des Verfahrens zur Bestimmung einer Kapazität nach dem verbesserten Konzept sowie des Verfahrens zur Detektion einer Benutzereingabe nach dem verbesserten Konzept und jeweils umgekehrt. Insbesondere kann eine Messanordnung nach dem verbesserten Konzept dazu eingerichtet sein, ein Verfahren nach dem verbesserten Konzept durchzuführen oder führt ein solches Verfahren durch.

Gemäß dem verbesserten Konzept wird auch ein Benutzereingabegerät, auch als Benutzereingabeschnittstelle bezeichnet, angegeben, insbesondere ein Benutzereingabegerät zur Verwendung in einem Kraftfahrzeuginnenraum. Das Benutzereingabegerät weist ein kapazitives Element auf, das zur Berührung durch einen Benutzer angeordnet ist. Das Benutzereingabegerät enthält eine Messanordnung zur Bestimmung einer Kapazität des kapazitiven Elements gemäß dem verbesserten Konzept.

Gemäß dem verbesserten Konzept wird auch ein Computerprogrammprodukt mit Befehlen angegeben. Bei Ausführung der Befehle durch eine Recheneinheit einer Messanordnung nach dem verbesserten Konzept veranlassen die Befehle die Messanordnung dazu, ein Verfahren nach dem verbesserten Konzept durchzuführen. Das Computerprogrammprodukt kann beispielsweise als Computerprogramm mit den Befehlen ausgestaltet sein. Das Computerprogrammprodukt kann auch als computerlesbares Speichermedium mit einem Computerprogramm ausgestaltet sein, das die Befehle beinhaltet.

Die Erfindung wird durch die beigefügten Ansprüche definiert.

In den Figuren zeigen:
- Fig. 1a: eine schematische Darstellung einer beispielhaften Ausführungsform einer Messanordnung gemäß dem verbesserten Konzept in einem Initialisierungszustand;
- Fig. 1b: eine schematische Darstellung der Messanordnung aus Fig. 1a in einem Zwischenzustand;
- Fig. 1c: eine schematische Darstellung der Messanordnung aus Fig. 1c und Fig. 1c in einem Ladezustand;
- Fig. 1d: eine schematische Darstellung der Messanordnung aus Fig. 1a bis 1c in einem Übertragungszustand:
- Fig. 1e: eine schematische Darstellung der Messanordnung aus Fig. 1a bis Fig. 1d in einem Auslesezustand;
- Fig. 2: ein Ablaufdiagramm einer beispielhaften Ausführungsform eines Verfahrens gemäß dem verbesserten Konzept; und
- Fig. 3: eine schematische Darstellung eines Messzyklus in einem Verfahren nach dem verbesserten Konzept.

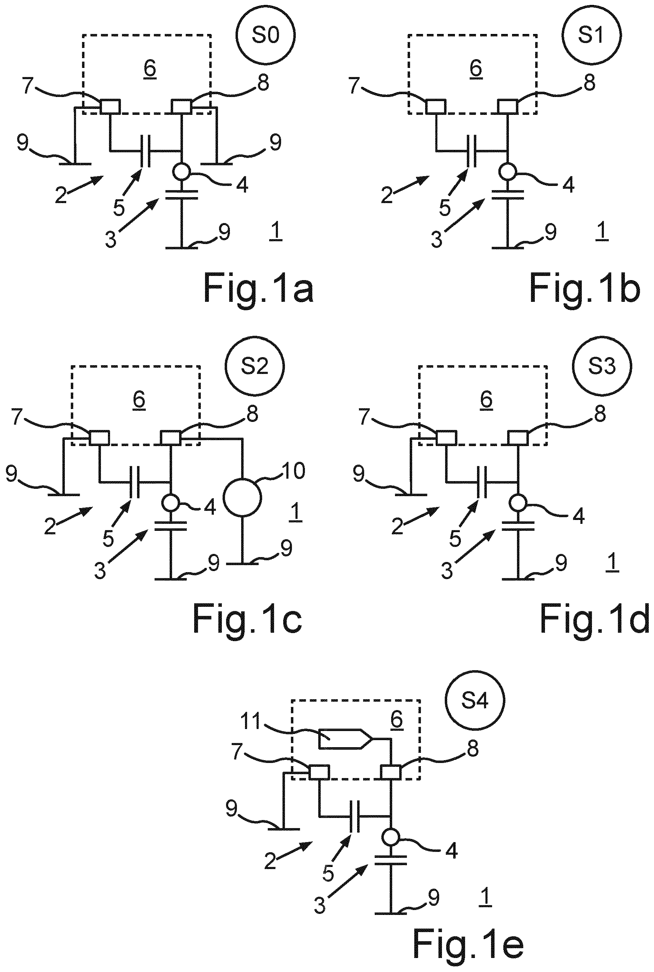

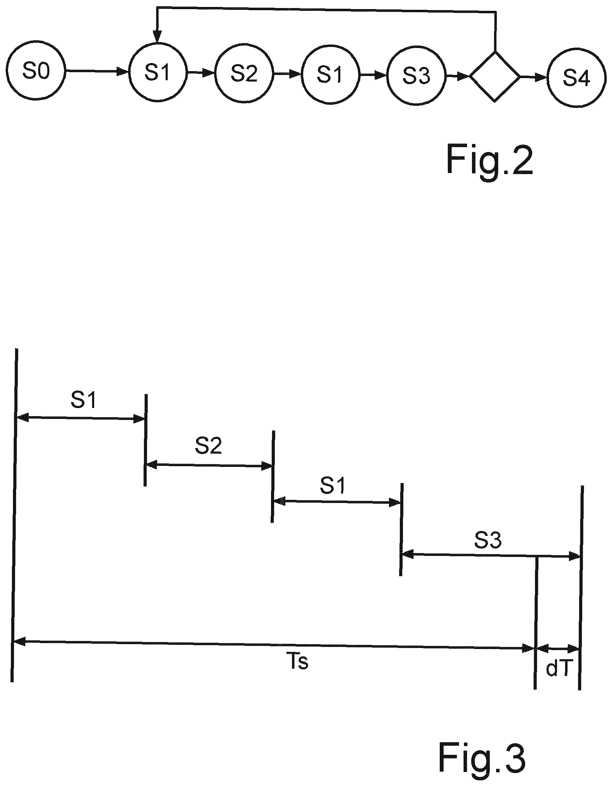

In Fig. 1a bis Fig. 1e ist eine beispielhafte Ausführungsform einer Messanordnung 2 nach dem verbesserten Konzept dargestellt, die beispielsweise Teil eines Benutzereingabegeräts 1, beispielsweise zum Einsatz im Innenraum eines Kraftfahrzeugs (nicht dargestellt). Die Fig. 1a bis Fig. 1e stellen dabei unterschiedliche Zustände der Messanordnung 2 entsprechend unterschiedlicher Abschnitte von Messzyklen in einem Verfahren nach dem verbesserten Konzept dar. Ein zugehöriges Ablaufdiagramm eines Verfahrens zur Detektion einer Benutzereingabe nach dem verbesserten Konzept ist in Fig. 2 dargestellt.

Das Benutzereingabegerät 1 weist ein kapazitives Element 3 auf, das zur Berührung durch einen Benutzer angeordnet und eingerichtet ist. Das kapazitive Element 3 kann beispielsweise als berührungsempfindliche Folie oder berührungsempfindliches Sensorplättchen ausgestaltet sein. Der Benutzer kann eine Oberfläche des kapazitiven Elements 3 beispielsweise berühren oder sich ihr mit einem Finger nähern, um eine Benutzereingabe zu tätigen. Durch die Annäherung oder Berührung des kapazitiven Elements 3 durch den Benutzer ändert sich dessen Kapazität. Die Messanordnung 2 ist dazu in der Lage, die Kapazität des kapazitiven Elements 3 zu bestimmen und basierend darauf auf das Vorliegen der Benutzereingabe zu schließen.

Die gemessene Kapazität des kapazitiven Elements 3 kann daher als Eigenkapazität gegenüber einem Massepotential verstanden werden. Daher ist in den Figuren Fig. 1a bis Fig. 1e das kapazitive Element 3 ebenfalls als Kondensator dargestellt, dessen erster Anschluss mit einem Referenzpotentialanschluss 9, insbesondere einem Masseanschluss, verbunden ist.

Die Messanordnung 2 weist einen Anschluss 4 auf, um das kapazitive Element 3, insbesondere den ersten Anschluss des kapazitiven Elements 3, mit der Messanordnung 2 zu verbinden, sowie ein weiteres kapazitives Element 5, das beispielsweise als Kondensator ausgestaltet sein kann.

Ein zweiter Anschluss des kapazitiven Elements 3 ist mit einem ersten Anschluss des weiteren kapazitiven Elements 5 verbunden. Der zweite Anschluss des kapazitiven Elements 3 ist dabei insbesondere direkt mit dem Sensorplättchen oder der berührungsempfindlichen Folie oder dergleichen verbunden oder wird dadurch gebildet. Ein zweiter Anschluss des weiteren kapazitiven Elements 5 ist mit einem ersten Anschluss 7 einer Recheneinheit 6 der Messanordnung 2 verbunden. Ein zweiter Anschluss 8 der Recheneinheit 6 ist mit dem zweiten Anschluss des kapazitiven Elements sowie mit dem ersten Anschluss des weiteren kapazitiven Elements 5 verbunden. Die Recheneinheit 6 kann beispielsweise einen Mikrocontroller oder einen sonstigen integrierten Schaltkreis beinhalten.

Die Messanordnung 2 weist auch einen Schaltkreis auf, der in den Figuren Fig. 1a bis Fig. 1e nicht separat dargestellt ist. Der Schaltkreis beinhaltet eine Steuerung sowie mehrere Schaltelemente, die von der Steuerung angesteuert werden können. Die Steuerung kann auch Teil der Recheneinheit 6 sein. Die Schaltelemente sind angeordnet und dazu eingerichtet, angesteuert durch die Steuerung, die Anschlüsse 7 und 8 der Recheneinheit 6 je nach aktuellem Zustand der Messanordnung 2 mit dem Referenzpotentialanschluss 9 zu verbinden oder von diesem zu trennen. Anhand der Schaltelemente kann die Steuerung des Weiteren eine Spannungsquelle 10, die beispielsweise Teil der Messanordnung 2 oder des Benutzereingabegeräts 1 sein kann oder extern zu diesen vorgesehen sein kann, mit dem zweiten Anschluss 8 der Recheneinheit 6 verbinden beziehungsweise die Verbindung trennen, je nach Zustand der Messanordnung 2.

Die Recheneinheit 6 weist außerdem einen Analog-Digital-Wandler, ADC, 11 auf, der mit dem zweiten Anschluss 8 verbindbar ist. Insbesondere kann der Schaltkreis den ADC 11 je nach Zustand der Messanordnung 2 mit dem zweiten Anschluss 8 verbinden oder davon trennen.

Bei der Durchführung eines Verfahrens nach dem verbesserten Konzept werden verschiedene Zustände S0, S1, S2, S3, S4 der Messanordnung 2, wie sie in Fig. 1a bis Fig. 1e dargestellt sind, zum Teil zyklisch beziehungsweise wiederholt durchlaufen, wie es beispielhaft in Fig. 2 dargestellt ist. S0 bezeichnet dabei einen Initialisierungszustand der Messanordnung 2 während eines Initialisierungsabschnitts des Verfahrens und S4 bezeichnet einen Auslesezustand der Messanordnung 2 während eines Ausleseabschnitts des Verfahrens.

Die Zustände S1 bis S3 bilden einen Messzyklus, wobei zur Durchführung des Verfahrens eine Vielzahl aufeinanderfolgender Messzyklen durchgeführt wird. Wie sich Fig. 2 entnehmen lässt, wird zur Bestimmung der Kapazität des kapazitiven Elements 3, beziehungsweise zur Detektion der Benutzereingabe, die Messanordnung 2 zunächst in den Initialisierungszustand S0 gebracht, danach wird die Vielzahl von Messzyklen durchgeführt und wiederum danach wird die Messanordnung 2 in den Auslesezustand S4 gebracht. Der in Fig. 2 skizzierte Ablauf kann auch als Messvorgang bezeichnet werden, wobei der Messvorgang im Betrieb der Messanordnung 2 beziehungsweise des Benutzereingabegeräts 1 ebenfalls wiederholt durchgeführt werden kann, um eine dauerhafte Überwachung des kapazitiven Elements 3 hinsichtlich einer Berührung durch den Benutzer zu realisieren.

In einer Ausführungsform des Verfahrens, wie es in Fig. 2 dargestellt ist, beinhaltet jeder Messzyklus einen Zwischenabschnitt, einen darauffolgenden Ladeabschnitt, einen darauf folgenden weiteren Zwischenabschnitt und einen darauf folgenden Übertragungsabschnitt. Dementsprechend wird die Messanordnung 2 während eines Messzyklus von einem mit S1 bezeichneten Zwischenzustand in einen mit S2 bezeichneten Ladezustand überführt, an den sich der Zwischenzustand S1 erneut anschließt, gefolgt von einem mit S3 bezeichneten Übertragungszustand. Nach Beendigung des Messzyklus wird mittels der Recheneinheit 6 überprüft, ob die vorgegebene Anzahl von Messzyklen pro Messvorgang erreicht ist. Ist dies der Fall, so wird die Messanordnung 2 in den Auslesezustand S4 gebracht, anderenfalls folgt der nächste Messzyklus.

Im Zustand S0 verbindet die Steuerung mittels des Schaltkreises den ersten Anschluss 7 sowie den zweiten Anschluss 8 jeweils mit dem Referenzpotentialanschluss 9. Damit sind der erste und der zweite Anschluss des kapazitiven Elements 3 sowie des weiteren kapazitiven Elements 5 jeweils mit dem Referenzpotentialanschluss 9 verbunden. Dementsprechend werden während des Initialisierungszustands S0 sowohl das kapazitive Element 3 als auch das weitere kapazitive Element 5 entladen. Im darauffolgenden ersten Zwischenabschnitt wird die Messanordnung 2 in den Zwischenzustand S1, der auch als Schaltzustand oder Umschaltzustand bezeichnet werden kann, gebracht. Hier werden die Anschlüsse 7 und 8 der Recheneinheit 6 von dem Referenzpotentialanschluss 9 getrennt. Die Messanordnung 2 bleibt während des Zwischenabschnitts für eine Zwischendauer, die beispielsweise kleiner als 1 µs ist, beispielsweise zwischen 0,1 µs und 1 µs liegt, in dem Zwischenzustand S1.

Danach überführt die Steuerung mittels des Schaltkreises die Messanordnung 2 in den Ladezustand S2. Im Vergleich zum Zwischenzustand S1 wird hier der zweite Anschluss 8 der Recheneinheit 6 mit der Spannungsquelle 10 verbunden, um so das kapazitive Element 3 zu laden. Indem beispielsweise der erste Anschluss 7 intern auf eine hohe Impedanz gesetzt wird, ändert sich dabei die Ladungsmenge auf dem weiteren kapazitiven Element 5 nicht. Der Ladezustand S2 wird für eine vorgegebene Ladedauer beibehalten, die beispielsweise im Bereich von 1 µs bis 10 µs liegen kann. Danach wird die Messanordnung 2 während eines weiteren Zwischenabschnitts wieder in den Zwischenzustand S1 gebracht. Eine weitere Zwischendauer des weiteren Zwischenabschnitts kann beispielsweise gleich der Zwischendauer des Zwischenabschnitts sein.

Während eines darauffolgenden Übertragungsabschnitts wird die Messanordnung 2 durch die Steuerung des Schaltkreises in den Übertragungszustand S3, der auch als Transferzustand bezeichnet werden kann, gebracht. Hier wird der zweite Anschluss 8 der Recheneinheit 6 nun auf eine hohe Impedanz gesetzt, und der erste Anschluss 7 wird mit dem Referenzpotentialanschluss 9 verbunden. Dadurch kann ein Ladungsausgleich zwischen dem kapazitiven Element 3 und dem weiteren kapazitiven Element 5 stattfinden. Die Kapazität des weiteren kapazitiven Element 5 ist um ein Vielfaches höher gewählt als die maximale Kapazität des weiteren kapazitiven Elements 3, so dass effektiv eine durch die beiden Kapazitäten bestimmte Ladungsmenge von dem kapazitiven Element 3 auf das weitere kapazitive Element 5 übertragen wird.

Eine Übertragungsdauer des Übertragungsabschnitts kann beispielsweise in einem Bereich von 0,5 µs bis 5 µs oder in einem Bereich von 0,5 µs bis 2 µs oder dergleichen liegen. Eine Auslesedauer des Auslesezeitraums kann beispielsweise in einem Bereich von 0,5 bis 5 µs oder einem Bereich von 0,5 µs bis 2 µs liegen.

Die Zustände S1, S2, S1, S3 werden in dieser Reihenfolge, wie in Fig. 2 angedeutet, zyklisch wiederholt, bis eine vorgegebene Gesamtzahl von Messzyklen durchlaufen wurde, beispielsweise 300 bis 500 Messzyklen. Nach der Gesamtzahl von Messzyklen wurde in den jeweiligen Übertragungsabschnitten insgesamt eine Gesamtladungsmenge von dem kapazitiven Element 3 auf das weitere kapazitive Element 5 übertragen. Diese Gesamtladungsmenge wird nun im darauffolgenden Ausleseabschnitt mittels der Recheneinheit 6 ausgelesen. Hierzu wird die Messanordnung 2 mittels der Steuerung und des Schaltkreises in den Auslesezustand S4 gebracht. Dazu bleibt der erste Anschluss 7 der Recheneinheit 6 mit dem Referenzpotentialanschluss 9 verbunden und der zweite Anschluss 8 der Recheneinheit 6 wird mit dem ADC 11 verbunden, um die Spannung zwischen Anschluss 4 der Messanordnung 2 und dem Referenzpotentialanschluss 9 zu messen und so einen Messwert zu bestimmen, der die Gesamtladungsmenge wiedergibt.

Nach dem Ausleseabschnitt kann die Recheneinheit 6 den so bestimmten Messwert mit einem vorgegeben Schwellwert vergleichen, um zu erkennen, ob eine Berührung des kapazitiven Elements 3 durch den Benutzer stattgefunden hat oder nicht. Ist der Messwert größer als der vorgegebene Grenzwert oder Schwellwert, so kann beispielsweise von einer Berührung ausgegangen werden.

Gemäß dem verbesserten Konzept sind die Gesamtzeitdauern der einzelnen Messzyklen der Vielzahl von Messzyklen nicht konstant. Dies ist schematisch für eine beispielhafte Ausführungsform in Fig. 3 skizziert. In der Ausführungsform gemäß Fig. 3 sind die Zwischendauern des Zwischenabschnitts und des weiteren Zwischenabschnitts sowie die Ladedauer des Ladeabschnitts jeweils konstant. Die Übertragungsdauer des Übertragungsabschnitts setzt sich zusammen aus einer vorgegebenen konstanten, also insbesondere für alle Messzyklen konstanten, Mindestübertragungsdauer und einer für unterschiedliche Messzyklen unterschiedlichen Zusatzzeitdauer dT. Die Summe der Mindestübertragungsdauer, der Ladedauer und den jeweiligen Zwischendauern der Zwischenabschnitte entspricht einer Mindestzeitdauer Ts für die Messzyklen. Mit anderen Worten ist die Zeitdauer eines Messzyklus gegeben durch die Summe aus der Mindestzeitdauer Ts und der Zusatzzeitdauer dT. Die Zusatzzeitdauer dT kann dabei insbesondere zwischen 0 und einer maximalen Zusatzzeitdauer systematisch variiert werden.

Es wird darauf hingewiesen, dass zur Variation der Zeitdauer des Messzyklus nicht notwendigerweise die Übertragungsdauer des Übertragungsabschnitts verändert werden muss beziehungsweise nicht notwendigerweise nur die Übertragungsdauer verändert werden muss. In anderen Ausführungsformen können auch die jeweiligen Zeitdauern eines oder mehrerer der weiteren Abschnitte variiert werden.

Beispielsweise kann die Recheneinheit 6 für jeden Messzyklus der Vielzahl von Messzyklen einen Zählerstand setzen, so dass sich der Zählerstand von 0 bis zu einem maximalen Zählerstand schrittweise erhöht. Die Zusatzzeitdauer dT kann dann mittels der Recheneinheit 6 abhängig von dem jeweiligen Zählerstand für den entsprechenden Messzyklus festgelegt werden. Dadurch kann beispielsweise die Zeitdauer (Ts + dT) für aufeinanderfolgende Messzyklen erhöht werden, indem die Zusatzzeitdauer dT entsprechend des jeweiligen Zählerstands erhöht wird.

Als Zähler kann beispielsweise ein software-basierter 4-Bit Zähler oder 5-Bit Zähler eingesetzt werden. Auch andere Zählergrößen sind selbstverständlich möglich. Im rein beispielhaften Fall eines 4 Bit-Zählers kann der Zähler also 16 Zählerstände von 0 bis 15 annehmen. Für einen gegebenen Zählerstand k kann die Zusatzzeitdauer dT also beispielsweise als dT = (k/16*ΔTs) festgelegt werden, wobei ΔTs der maximalen Zusatzzeitdauer entspricht. Alternativ kann auch dT = ([(n+1)/16]*ΔTs) als Zusatzzeitdauer verwendet werden, so dass die Zusatzzeitdauer dT von ΔTs/16 bis ΔTs läuft.

Geht man beispielhaft von einer Anzahl von 300 bis 500 Messzyklen pro Messvorgang aus, so wird bei einem 4 Bit-Zähler der Wertebereich des Zählers während eines Messvorgangs vielfach durchlaufen. Für den darauffolgenden Messvorgang muss der Zähler nicht notwendigerweise zurückgesetzt werden.

Durch die schrittweise Variation der Zeitdauer (Ts + dT) der Messzyklen eines Messvorgangs, beziehungsweise gegebenenfalls auch mehrerer aufeinanderfolgende Messvorgänge, kann verhindert werden, dass bei einer externen Störung mit einer mehr oder weniger konstanten Frequenz in der Größenordnung 1/Ts eine signifikante Beeinflussung der Genauigkeit der Kapazitätsmessung resultiert.

Wie beschrieben, insbesondere hinsichtlich der Figuren, erlaubt es das verbesserte Konzept also die Kapazität eines kapazitiven Elements mit höherer Zuverlässigkeit und insbesondere reduziertem Einfluss von externen Störungen zu bestimmen. Dabei werden die entsprechenden Messzyklen künstlich erweitert. Die Erweiterung kann prinzipiell in einem beliebigen Zustand der Messanordnung beziehungsweise ein einem beliebigen Abschnitt des Messzyklus vorgenommen werden. Der Übertragungszustand ist dahingehend besonders geeignet, um Stromleckagen zu vermeiden. Die Erweiterung könnte aber auch während des Ladezustands oder der Zwischenzustände erfolgen. Die Zeitdauer des Messzyklus kann in verschiedenen Ausführungsbeispielen kontinuierlich um einen Anteil von wenigen Prozent, beispielsweise 1 bis 3 %, erhöht werden. Externe Störungen haben daher nur noch einen Bruchteil des Einflusses, wie es ohne das verbesserte Konzept der Fall wäre. Eine fehlerhafte Berührungserkennung kann dadurch vermieden werden.

## Patentansprüche

1. Verfahren zur Bestimmung einer Kapazität eines kapazitiven Elements (3), wobei
- während jedes Messzyklus einer Vielzahl aufeinanderfolgender Messzyklen das kapazitive Element (3) geladen wird und anschließend eine Ladungsmenge von dem kapazitiven Element (3) auf ein weiteres kapazitives Element (5) übertragen wird;
- nach der Vielzahl von Messzyklen ein Messwert betreffend eine während der Vielzahl von Messzyklen insgesamt auf das weitere kapazitive Element (5) übertragene Gesamtladungsmenge bestimmt wird; und
- die Kapazität des kapazitiven Elements (3) abhängig von dem Messwert bestimmt wird; wobei mittels einer Recheneinheit (6)
- für eine erste Untermenge der Vielzahl von Messzyklen eine erste Zeitdauer festgelegt wird; und
- für eine zweite Untermenge der Vielzahl von Messzyklen eine zweite Zeitdauer festgelegt wird, die sich von der ersten Zeitdauer unterscheidet;
- jeder der Messzyklen einen Ladeabschnitt enthält, wobei das Laden des kapazitiven Elements (3) während des Ladeabschnitts erfolgt;
- jeder der Messzyklen einen Übertragungsabschnitt enthält, wobei das Übertragen der Ladungsmenge von dem kapazitiven Element (3) auf das weitere kapazitive Element (5) während des Übertragungsabschnitts erfolgt;
- jeder der Messzyklen einen Zwischenabschnitt zwischen dem Ladeabschnitt und dem Übertragungsabschnitt enthält, wobei das kapazitive Element (3) während des Zwischenabschnitts weder geladen noch entladen wird; und/oder
- jeder der Messzyklen einen weiteren Zwischenabschnitt vor dem Ladeabschnitt oder nach dem Übertragungsabschnitt enthält, wobei das kapazitive Element (3) während des weiteren Zwischenabschnitts weder geladen noch entladen wird;
**dadurch gekennzeichnet, dass**
- zum Festlegen der ersten Zeitdauer eine erste Zwischendauer für den jeweiligen Zwischenabschnitt der Messzyklen der ersten Untermenge festgelegt wird und zum Festlegen der zweiten Zeitdauer eine zweite Zwischendauer für den jeweiligen Zwischenabschnitt der Messzyklen der zweiten Untermenge festgelegt wird, wobei sich die zweite Zwischendauer von der ersten Zwischendauer unterscheidet;
und/oder
- zum Festlegen der ersten Zeitdauer eine erste weitere Zwischendauer für den jeweiligen weiteren Zwischenabschnitt der Messzyklen der ersten Untermenge festgelegt wird und zum Festlegen der zweiten Zeitdauer eine zweite weitere Zwischendauer für den jeweiligen weiteren Zwischenabschnitt der Messzyklen der zweiten Untermenge festgelegt wird, wobei sich die zweite weitere Zwischendauer von der ersten weiteren Zwischendauer unterscheidet.

2. Verfahren nach Anspruch 1,
**dadurch gekennzeichnet, dass**
- zum Festlegen der ersten Zeitdauer eine erste Ladedauer für den jeweiligen Ladeabschnitt der Messzyklen der ersten Untermenge festgelegt wird und zum Festlegen der zweiten Zeitdauer eine zweite Ladedauer für den jeweiligen Ladeabschnitt der Messzyklen der zweiten Untermenge festgelegt wird, wobei sich die zweite Ladedauer von der ersten Ladedauer unterscheidet; und/oder
- zum Festlegen der ersten Zeitdauer eine erste Übertragungsdauer für den jeweiligen Übertragungsabschnitt der Messzyklen der ersten Untermenge festgelegt wird und zum Festlegen der zweiten Zeitdauer eine zweite Übertragungsdauer für den jeweiligen Übertragungsabschnitt der Messzyklen der zweiten Untermenge festgelegt wird, wobei sich die zweite Übertragungsdauer von der ersten Übertragungsdauer unterscheidet.

3. Verfahren nach einem der vorhergehenden Ansprüche,
**dadurch gekennzeichnet, dass**
mittels der Recheneinheit (6) für jeden Messzyklus der Vielzahl von Messzyklen ein Zählerstand eines Zähler gesetzt wird und eine Zeitdauer für den jeweiligen Messzyklus abhängig von dem jeweiligen gesetzten Zählerstand festgelegt wird.

4. Verfahren nach Anspruch 3,
**dadurch gekennzeichnet, dass**
- der Zählerstand ausgehend von einem initialen Zählerstand für jeden der Messzyklen um ein vorgegebenes Inkrement erhöht wird, solange der Zählerstand kleiner oder gleich einem vorgegebenen maximalen Zählerstand ist; und
- der Zählerstand auf den initialen Zählerstand zurückgesetzt wird, wenn der Zählerstand den maximalen Zählerstand erreicht hat.

5. Verfahren nach Anspruch 4,
**dadurch gekennzeichnet, dass**
der Zusammenhang N ≤ M gilt, wobei M eine Anzahl der Messzyklen der Vielzahl von Messzyklen bezeichnet, (N-1)*I eine ganze Zahl ist, die eine Differenz zwischen dem maximalen Zählerstand und dem initialen Zählerstand bezeichnet, und I das Inkrement bezeichnet.

6. Verfahren nach einem der Ansprüche 3 bis 5,
**dadurch gekennzeichnet, dass**
mittels der Recheneinheit (6) für jeden Messzyklus der Vielzahl von Messzyklen die jeweilige Zeitdauer als Summe einer vorgegebenen für alle Messzyklen konstanten Mindestzeitdauer und einer von dem jeweiligen gesetzten Zählerstand abhängigen zusätzlichen Zeitdauer festgelegt wird.

7. Verfahren nach Anspruch 6,
**dadurch gekennzeichnet, dass** die Mindestzeitdauer in einem Bereich zwischen 0,5 µs und 30 µs, insbesondere in einem Bereich zwischen 1 µs und 20 µs, liegt.

8. Verfahren nach einem der Ansprüche 6 oder 7,
**dadurch gekennzeichnet, dass**
die jeweilige zusätzliche Zeitdauer kleiner oder gleich einem Zehntel der Mindestzeitdauer ist, insbesondere kleiner oder gleich einem Fünfzigstel der Mindestzeitdauer, beispielsweise kleiner oder gleich einem Hundertstel der Mindestzeitdauer.

9. Verfahren zur Detektion einer Benutzereingabe, die eine Berührung eines kapazitiven Elements (3) durch einen Benutzer beinhaltet,
**dadurch gekennzeichnet, dass**
- ein Verfahren zur Bestimmung einer Kapazität des kapazitiven Elements (3) nach einem der vorhergehenden Ansprüche durchgeführt wird;
- die bestimmte Kapazität des kapazitiven Elements (3) mittels der Recheneinheit (6) mit einem vorgegebenen Schwellwert verglichen wird; und
- die Benutzereingabe oder die Berührung mittels der Recheneinheit (6) abhängig von einem Ergebnis des Vergleichs detektiert wird.

10. Messanordnung zur Bestimmung einer Kapazität eines kapazitiven Elements (3), die dazu eingerichtet das Verfahren gemäß einem der Ansprüche 1 bis 9 durchzuführen, die Messanordnung (2) aufweisend
- einen Anschluss (4), um das kapazitive Element (3) mit der Messanordnung (2) zu verbinden;
- einen Schaltkreis, der dazu eingerichtet ist, während jedes Messzyklus einer Vielzahl aufeinanderfolgender Messzyklen
- das kapazitive Element (3) mit einer Spannungsquelle (10) zu verbinden, um das kapazitive Element (3) zu laden; und
- anschließend eine Ladungsmenge von dem kapazitiven Element (3) auf ein weiteres kapazitives Element (5) der Messanordnung (2) zu übertragen; und
- eine Recheneinheit (6), die dazu eingerichtet ist, nach der Vielzahl von Messzyklen einen Messwert betreffend eine während der Vielzahl von Messzyklen insgesamt auf das weitere kapazitive Element (4) übertragene Gesamtladungsmenge zu bestimmen und die Kapazität des kapazitiven Elements (3) abhängig von dem Messwert zu bestimmen;
**dadurch gekennzeichnet, dass** die Recheneinheit (6) dazu eingerichtet ist,
- für eine erste Untermenge der Vielzahl von Messzyklen eine erste Zeitdauer festzulegen; und
- für eine zweite Untermenge der Vielzahl von Messzyklen eine zweite Zeitdauer festzulegen.

11. Benutzereingabegerät aufweisend ein kapazitives Element (3), das zur Berührung durch einen Benutzer angeordnet ist,
**dadurch gekennzeichnet, dass**
das Benutzereingabegerät (1) eine Messanordnung (2) zur Bestimmung einer Kapazität des kapazitiven Elements (3) gemäß Anspruch 10 enthält.

12. Computerprogrammprodukt mit Befehlen, die bei Ausführung durch eine Recheneinheit (6) einer Messanordnung (2) nach Anspruch 10 die Messanordnung (2) dazu veranlassen, ein Verfahren nach einem der Ansprüche 1 bis 9 auszuführen.

## Claims

1. Method for determining a capacitance of a capacitive element (3), wherein,
- during each measurement cycle of a plurality of successive measurement cycles, the capacitive element (3) is charged and an amount of charge is subsequently transferred from the capacitive element (3) to a further capacitive element (5);
- following the plurality of measurement cycles, a measured value relating to a total amount of charge transferred as a whole to the further capacitive element (5) during the plurality of measurement cycles is determined; and
- the capacitance of the capacitive element (3) is determined depending on the measured value;
wherein, by means of a computing unit (6),
- a first period is defined for a first subset of the plurality of measurement cycles; and
- a second period is defined for a second subset of the plurality of measurement cycles, said second period differing from the first period;
- each of the measurement cycles contains a charging section, wherein the capacitive element (3) is charged during the charging section;
- each of the measurement cycles contains a transfer section, wherein the amount of charge is transferred from the capacitive element (3) to the further capacitive element (5) during the transfer section;
- each of the measurement cycles contains an intermediate section between the charging section and the transfer section, wherein the capacitive element (3) is neither charged nor discharged during the intermediate section; and/or
- each of the measurement cycles contains a further intermediate section upstream of the charging section or downstream of the transfer section, wherein the capacitive element (3) is neither charged nor discharged during the further intermediate section;
**characterized in that**
- a first intermediate duration is defined for the respective intermediate section of the measurement cycles of the first subset in order to define the first period and a second intermediate duration is defined for the respective intermediate section of the measurement cycles of the second subset in order to define the second period, wherein the second intermediate duration differs from the first intermediate duration; and/or
- a first further intermediate duration is defined for the respective further intermediate section of the measurement cycles of the first subset in order to define the first period and a second further intermediate duration is defined for the respective further intermediate section of the measurement cycles of the second subset in order to define the second period, wherein the second further intermediate duration differs from the first further intermediate duration.

2. Method according to Claim 1,
**characterized in that**
- a first charging duration is defined for the respective charging section of the measurement cycles of the first subset in order to define the first period and a second charging duration is defined for the respective charging section of the measurement cycles of the second subset in order to define the second period, wherein the second charging duration differs from the first charging duration; and/or
- a first transfer duration is defined for the respective transfer section of the measurement cycles of the first subset in order to define the first period and a second transfer duration is defined for the respective transfer section of the measurement cycles of the second subset in order to define the second period, wherein the second transfer duration differs from the first transfer duration.

3. Method according to either of the preceding claims, **characterized in that**,
by means of the computing unit (6), a counter reading of a counter is set for each measurement cycle of the plurality of measurement cycles, and a period is defined for the respective measurement cycle depending on the respective set counter reading.

4. Method according to Claim 3,
**characterized in that**,
- starting from an initial counter reading for each of the measurement cycles, the counter reading is increased by a predefined increment for as long as the counter reading is lower than or equal to a predefined maximum counter reading; and
- the counter reading is reset to the initial counter reading if the counter reading has reached the maximum counter reading.

5. Method according to Claim 4,
**characterized in that**
the relationship N ≤ M applies, wherein M designates a number of measurement cycles of the plurality of measurement cycles, (N-1)*I is an integer that designates a difference between the maximum counter reading and the initial counter reading, and I designates the increment.

6. Method according to one of Claims 3 to 5,
**characterized in that**,
by means of the computing unit (6), for each measurement cycle of the plurality of measurement cycles, the respective period is defined as the sum of a predefined minimum period that is constant for all the measurement cycles and an additional period that is dependent on the respective set counter reading.

7. Method according to Claim 6,
**characterized in that** the minimum period is in a range between 0.5 µs and 30 µs, in particular in a range between 1 µs and 20 µs.

8. Method according to either of Claims 6 and 7,
**characterized in that**
the respective additional period is shorter than or equal to a tenth of the minimum period, in particular shorter than or equal to a fiftieth of the minimum period, for example shorter than or equal to a hundredth of the minimum period.

9. Method for detecting a user input that includes a user touching a capacitive element (3),
**characterized in that**
- a method for determining a capacitance of the capacitive element (3) according to one of the preceding claims is carried out;
- the determined capacitance of the capacitive element (3) is compared with a predefined threshold value by means of the computing unit (6); and
- the user input or the touching is detected by means of the computing unit (6) depending on a result of the comparison.

10. Measuring arrangement for determining a capacitance of a capacitive element (3) that is configured to carry out the method according to one of Claims 1 to 9, the measuring arrangement (2) having
- a connection (4) to connect the capacitive element (3) to the measuring arrangement (2);
- a circuit that is configured, during each measurement cycle of a plurality of successive measurement cycles,
- to connect the capacitive element (3) to a voltage source (10) in order to charge the capacitive element (3); and
- to subsequently transfer an amount of charge from the capacitive element (3) to a further capacitive element (5) of the measuring arrangement (2); and
- a computing unit (6) that is configured, following the plurality of measurement cycles, to determine a measured value relating to a total amount of charge transferred as a whole to the further capacitive element (4) during the plurality of measurement cycles and to determine the capacitance of the capacitive element (3) depending on the measured value;
**characterized in that** the computing unit (6) is configured
- to define a first period for a first subset of the plurality of measurement cycles; and
- to define a second period for a second subset of the plurality of measurement cycles.

11. User input device having a capacitive element (3) that is arranged so as to be touched by a user, **characterized in that**
the user input device (1) contains a measuring arrangement (2) for determining a capacitance of the capacitive element (3) according to Claim 10.

12. Computer program product having instructions, which, when executed by a computing unit (6) of a measuring arrangement (2) according to Claim 10, cause the measuring arrangement (2) to execute a method according to one of Claims 1 to 9.

## Revendications

1. Procédé de détermination de la capacité d'un élément capacitif (3), dans lequel
- pendant chaque cycle de mesure d'une pluralité de cycles de mesure successifs, l'élément capacitif (3) est chargé, puis une quantité de charge est transférée de l'élément capacitif (3) vers un autre élément capacitif (5) ;
- après la pluralité de cycles de mesure, une valeur de mesure concernant une quantité de charge totale transférée vers l'autre élément capacitif (5) pendant la pluralité de cycles de mesure est déterminée ; et
- la capacité de l'élément capacitif (3) est déterminée en fonction de la valeur de mesure ;
dans lequel, au moyen d'une unité de calcul (6),
- une première durée est définie pour un premier sous-ensemble de la pluralité de cycles de mesure ; et
- une seconde durée qui diffère de la première durée est définie pour un second sous-ensemble de la pluralité de cycles de mesure ;
- chacun des cycles de mesure contient une partie de charge, la charge de l'élément capacitif (3) s'effectuant pendant la partie de charge ;
- chacun des cycles de mesure contient une partie de transfert, le transfert de la quantité de charge de l'élément capacitif (3) vers l'autre élément capacitif (5) s'effectuant pendant la partie de transfert ;
- chacun des cycles de mesure contient une partie intermédiaire entre la partie de charge et la partie de transfert, l'élément capacitif (3) n'étant ni chargé ni déchargé pendant la partie intermédiaire ; et/ou
- chacun des cycles de mesure contient une autre partie intermédiaire avant la partie de charge ou après la partie de transfert, l'élément capacitif (3) n'étant ni chargé ni déchargé pendant cette autre partie intermédiaire ;
**caractérisé en ce que**,
- pour définir la première durée, une première durée intermédiaire est définie pour la partie intermédiaire respective des cycles de mesure du premier sous-ensemble, et pour définir la seconde durée, une seconde durée intermédiaire est définie pour la partie intermédiaire respective des cycles de mesure du second sous-ensemble, la seconde durée intermédiaire différant de la première durée intermédiaire ; et/ou
- pour définir la première durée, une première autre durée intermédiaire est définie pour l'autre partie intermédiaire respective des cycles de mesure du premier sous-ensemble, et pour définir la seconde durée, une seconde autre durée intermédiaire est définie pour l'autre partie intermédiaire respective des cycles de mesure du second sous-ensemble, la seconde autre durée intermédiaire différant de la première autre durée intermédiaire.

2. Procédé selon la revendication 1,
**caractérisé en ce que**,
- pour définir la première durée, une première durée de charge est définie pour la partie de charge respective des cycles de mesure du premier sous-ensemble, et pour définir la seconde durée, une seconde durée de charge est définie pour la partie de charge respective des cycles de mesure du second sous-ensemble, la seconde durée de charge différant de la première durée de charge ; et/ou
- pour définir la première durée, une première durée de transfert est définie pour la partie de transfert respective des cycles de mesure du premier sous-ensemble, et pour définir la seconde durée, une seconde durée de transfert est définie pour la partie de transfert respective des cycles de mesure du second sous-ensemble, la seconde durée de transfert différant de la première durée de transfert.

3. Procédé selon l'une des revendications précédentes, **caractérisé en ce que**,
au moyen de l'unité de calcul (6), un état de compteur d'un compteur est défini pour chaque cycle de mesure de la pluralité de cycles de mesure, et une durée est définie pour le cycle de mesure respectif en fonction de l'état de compteur défini.

4. Procédé selon la revendication 3,
**caractérisé en ce que**
- l'état de compteur est augmenté d'un incrément prédéfini pour chacun des cycles de mesure, à partir d'un état de compteur initial, tant que l'état de compteur est inférieur ou égal à un état de compteur maximal prédéfini ; et
- l'état de compteur est réinitialisé à l'état de compteur initial lorsque l'état de compteur a atteint l'état de compteur maximal.

5. Procédé selon la revendication 4,
**caractérisé en ce que**
la relation N ≤ M s'applique, M désignant un nombre de cycles de mesure de la pluralité de cycles de mesure, (N-1)*I étant un entier qui désigne une différence entre l'état de compteur maximal et l'état de compteur initial, et I désignant l'incrément.

6. Procédé selon l'une des revendications 3 à 5, **caractérisé en ce que**,
au moyen de l'unité de calcul (6), la durée respective pour chaque cycle de mesure de la pluralité de cycles de mesure est définie comme la somme d'une durée minimale constante prédéfinie pour tous les cycles de mesure et d'une durée supplémentaire dépendant de l'état de compteur défini.

7. Procédé selon la revendication 6,
**caractérisé en ce que** la durée minimale se situe dans une plage comprise entre 0,5 µs et 30 µs, en particulier dans une plage comprise entre 1 µs et 20 µs.

8. Procédé selon l'une des revendications 6 ou 7, **caractérisé en ce que**
la durée supplémentaire respective est inférieure ou égale à un dixième de la durée minimale, en particulier inférieure ou égale à un cinquantième de la durée minimale, par exemple inférieure ou égale à un centième de la durée minimale.

9. Procédé de détection d'une entrée d'utilisateur qui implique un contact tactile d'un élément capacitif (3) par un utilisateur,
**caractérisé en ce que**
- un procédé de détermination de la capacité de l'élément capacitif (3) selon l'une des revendications précédentes est mis en œuvre ;
- la capacité déterminée de l'élément capacitif (3) est comparée au moyen de l'unité de calcul (6) à une valeur de seuil prédéfinie ; et
- l'entrée utilisateur ou le contact tactile est détecté au moyen de l'unité de calcul (6) en fonction d'un résultat de la comparaison.

10. Dispositif de mesure destiné à déterminer la capacité d'un élément capacitif (3), qui est conçu pour mettre en œuvre le procédé selon l'une des revendications 1 à 9, le dispositif de mesure (2) comprenant
- une connexion (4) permettant de relier l'élément capacitif (3) au dispositif de mesure (2) ;
- un circuit qui est conçu, pendant chaque cycle de mesure d'une pluralité de cycles de mesure successifs, pour
- relier l'élément capacitif (3) à une source de tension (10) afin de charger l'élément capacitif (3) ; et
- transférer ensuite une quantité de charge de l'élément capacitif (3) à un autre élément capacitif (5) du dispositif de mesure (2) ; et
- une unité de calcul (6) qui est conçue pour déterminer, après la pluralité de cycles de mesure, une valeur de mesure concernant une quantité de charge totale transférée à l'autre élément capacitif (4) pendant la pluralité de cycles de mesure et pour déterminer la capacité de l'élément capacitif (3) en fonction de la valeur de mesure ;
**caractérisé en ce que** l'unité de calcul (6) est conçue pour
- définir une première durée pour un premier sous-ensemble de la pluralité de cycles de mesure ; et
- définir une seconde durée pour un second sous-ensemble de la pluralité de cycles de mesure.

11. Appareil d'entrée utilisateur comprenant un élément capacitif (3) qui est agencé de manière être touché par un utilisateur,
**caractérisé en ce que**
l'appareil d'entrée utilisateur (1) contient un dispositif de mesure (2) destiné à déterminer une capacité de l'élément capacitif (3) selon la revendication 10.

12. Produit de programme informatique comprenant des instructions qui, lorsqu'elles sont exécutées par une unité de calcul (6) d'un dispositif de mesure (2) selon la revendication 10, amènent le dispositif de mesure (2) à mettre en œuvre un procédé selon l'une des revendications 1 à 9.
